(19) Europäisches Patentamt
European Patent Office
Office européen des brevets

(11) EP 1 550 677 B1

(12) **EUROPEAN PATENT SPECIFICATION**

(45) Date of publication and mention of the grant of the patent:
**28.02.2007 Bulletin 2007/09**

(21) Application number: **03771376.5**

(22) Date of filing: **28.07.2003**

(51) Int Cl.:
*C08G 59/40* (2006.01) *G03H 1/02* (2006.01)
*G03F 7/004* (2006.01) *G03F 7/038* (2006.01)
*G03F 7/40* (2006.01)

(86) International application number:
**PCT/JP2003/009524**

(87) International publication number:
**WO 2004/011522 (05.02.2004 Gazette 2004/06)**

(54) **COMPOSITION FOR HOLOGRAPHY, METHOD OF CURING THE SAME, AND CURED ARTICLE**

ZUSAMMENSETZUNG FÜR DIE HOLOGRAPHIE, VERFAHREN ZU IHRER HÄRTUNG UND GEHÄRTETER GEGENSTAND

COMPOSITION D'HOLOGRAPHIE, SON PROCEDE DE DURCISSEMENT ET ARTICLE DURCI

(84) Designated Contracting States:
**AT BE BG CH CY CZ DE DK EE ES FI FR GB GR HU IE IT LI LU MC NL PT RO SE SI SK TR**

(30) Priority: **30.07.2002 JP 2002220740**
**05.03.2003 JP 2003058010**

(43) Date of publication of application:
**06.07.2005 Bulletin 2005/27**

(73) Proprietor: **TOAGOSEI CO., LTD.**
**Tokyo 105-8419 (JP)**

(72) Inventors:
- **KATOU, Hisao,**
**Toagosei Co., Ltd.**
**Minato-ku (JP)**
- **SASAKI, Hiroshi,**
**Toagosei Co., Ltd.**
**Minato-ku (JP)**

(74) Representative: **TBK-Patent**
**Bavariaring 4-6**
**80336 München (DE)**

(56) References cited:
**EP-A- 0 697 631**
**EP-A- 0 945 762**
**WO-A1-97/13183**
**WO-A1-99/26112**
**JP-A- 7 005 796**
**JP-A- 2000 047 552**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 550 677 B1

## Description

### TECHNICAL FIELD

The present invention relates to a composition for hologram recording that contains a cationically polymerizable compound, to a curing method for the same, and to a cured article of the same.

### BACKGROUND ART

Various materials have been disclosed in recent years as materials for hologram recording. For example, materials for hologram recording are disclosed in JP-A-5-107999, JP-A-6-301322, and JP-A-7-104644 in which an interference pattern is formed by radical-polymerizable monomers or oligomers. However, when a radical-polymerizable compound is used, since polymerization is inhibited by oxygen in the atmosphere, oxygen must be eliminated from the material for hologram recording and from the environment in which it is used. According to the radical-polymerizable compound used, since there is significant curing shrinkage that accompanies polymerization, and the interference pattern thus formed fluctuates or becomes distorted, a good hologram sometimes cannot be obtained, and its use is limited.

JP-A-11-512847, JP-A-2001-523842, Non-patent Reference 1, and other publications disclose techniques whereby a cationically polymerizable compound that has less curing shrinkage during polymerization than a radical-polymerizable compound is used in the material for hologram recording, and fluctuation or distortion in the interference pattern is overcome. Particularly, the performing of Non-holographic Pre-Imaging Exposure prior to formation of an interference pattern in the material for hologram recording is disclosed in *J. Imag. Sci. Technol.,* vol. 41, (5), pp. 497-514 (1997). Suggested reasons for performing this exposure are: 1) since the periphery of the interference pattern is liquid even when an interference pattern is formed in a liquid material for hologram recording, and the interference pattern thus formed easily fluctuates and becomes disordered, fluctuation of the interference pattern is minimized by curing a portion of the material for hologram recording and reducing or eliminating the fluidity thereof; and 2) by polymerizing a portion of the material for hologram recording in advance, the curing shrinkage that occurs during formation of the interference pattern is further reduced. However, a thick holographic coating sometimes cannot be satisfactorily formed by the technique, and the use thereof is limited. A material for hologram recording that has a cationically polymerizable compound as one of its main components is also considered for digital recording applications, but such applications require a material for hologram recording having a fast write speed. The material for hologram recording described in the prior art sometimes cannot provide a sufficiently high write speed, and has limited use in digital recording applications.

An object of the present invention is to provide a composition for hologram recording in which the drawbacks of the prior art are overcome, with which a thick, high-sensitivity holographic coating can be satisfactorily formed, and which has low curing shrinkage; to provide a curing method for the same; and to provide a cured article.

### DISCLOSURE OF THE INVENTION

The present invention is a composition for hologram recording comprising a cationically polymerizable compound, a compound whose refractive index differs by 0.005 or more from that of a cured article of the cationically polymerizable compound, a thermal cationic polymerization initiator, and an optical cationic polymerization initiator.

In the preferred composition for hologram recording of the present invention, the cationically polymerizable compound is an epoxy compound.

In the preferred composition for hologram recording of the present invention, the cationically polymerizable compound is composed of a polyfunctional cationically polymerizable compound and a monofunctional cationically polymerizable compound.

In the preferred composition for hologram recording of the present invention, the polyfunctional cationically polymerizable compound is a polyfunctional epoxy compound having a siloxane bond.

In the preferred composition for hologram recording of the present invention, the monofunctional cationically polymerizable compound is a monofunctional epoxy compound having a siloxane bond.

In the preferred composition for hologram recording of the present invention, the thermal cationic polymerization initiator is composed of an aluminum compound and a compound having a silanol group.

The curing method for the composition for hologram recording of the present invention comprises the steps of forming the composition for hologram recording into a liquid film; heat curing the liquid film and forming a semi-cured film; and irradiating the semi-cured film with coherent light and forming an interference pattern.

The cured article of the present invention is obtained by curing the composition for hologram recording of the present invention by the curing method.

BEST MODE FOR CARRYING OUT THE INVENTION

In the present specification, the term "polyfunctional" means bifunctional or higher.

The composition for hologram recording of the present invention contains a cationically polymerizable compound, a compound whose refractive index differs by 0.005 or more from that of a cured article of the cationically polymerizable compound, a thermal cationic polymerization initiator, and an optical cationic polymerization initiator.

(Cationically polymerizable compound)

The cationically polymerizable compound is a principal component for imparting curability to the composition for hologram recording, and for creating holographic capability.

Cationically polymerizable compounds include epoxy compounds, oxetane compounds, and the like. An epoxy compound is the preferred cationically polymerizable compound because of the ease with which epoxy compounds having various structures can be acquired or prepared, and with which the refractive index, compatibility thereof with other components, or other characteristics thereof can be adjusted.

No particular limitation is placed on the epoxy compound, which may include an aromatic epoxy compound, an alicyclic epoxy compound, an aliphatic epoxy compound, or the like, and any compound including monomers, oligomers, and polymers having an epoxy group can be used.

Aromatic epoxy compounds include di- or polyglycidyl ethers manufactured by reacting a polyvalent phenol having at least one aromatic nucleus, or an alkylene oxide adduct thereof with epichlorohydrin. Specific examples thereof include di- or polyglycidyl ethers of bisphenol A or an alkylene oxide adduct thereof; di- or polyglycidyl ethers of hydrogenated bisphenol A or an alkylene oxide adduct thereof; Novolak epoxy compounds; and the like. The alkylene oxide in this case includes ethylene oxide, propylene oxide, or the like.

Alicyclic epoxy compounds include those obtained by epoxidation of a compound having at least one cyclohexene or cyclopentene ring or other cycloalkane ring with hydrogen peroxide or another appropriate oxidizing agent. A compound having a cyclohexene oxide or cyclopentene oxide backbone is preferred, and specific examples thereof include 3,4-epoxycyclohexyl methyl-3,4-epoxycyclohexyl carboxylate, *bis* [2-(3,4-epoxycyclohexyl)ethyl]tetramethyl disiloxane, [2-(3,4-epoxycyclohexyl)ethyl]pentamethyl disiloxane, alicyclic epoxy compounds having the structure indicated by chemical formula (1) below, and the like.

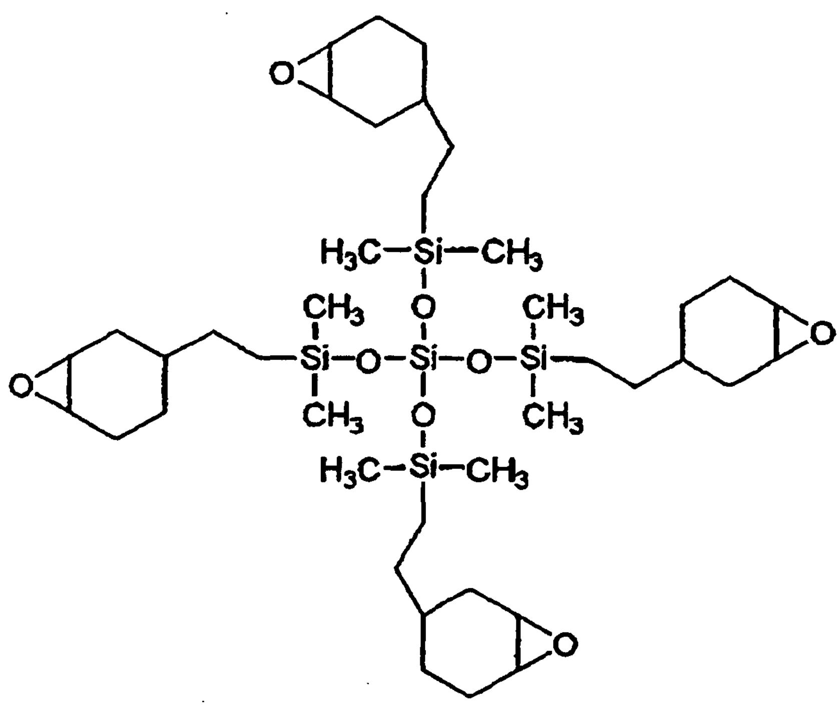

(1)

Aliphatic epoxy compounds include di- or polyglycidyl ethers of aliphatic polyhydric alcohols or alkylene oxide adducts thereof, and the like. Typical examples thereof include diglycidyl ethers of ethylene glycol, diglycidyl ethers of

propylene glycol, diglycidyl ethers of 1,6-hexanediols, and other diglycidyl ethers of alkylene glycols; di- or triglycidyl ethers of glycerin or an alkylene oxide adduct thereof, and other polyglycidyl ethers of polyhydric alcohols; diglycidyl ethers of polyethylene glycol or an alkylene oxide adduct thereof; diglycidyl ethers of polyalkylene glycols such as diglycidyl ethers of polypropylene glycol or an alkylene oxide adduct thereof; and the like. The alkylene oxide in this case includes ethylene oxide, propylene oxide, or the like.

Among the epoxy compounds, an alicyclic epoxy compound is preferred because the compound has good polymerization reactivity during interference pattern formation and yields good holographic records. Particularly preferred are *bis*[2-(3,4-epoxycyclohexyl) ethyl] tetramethyl disiloxane, [2-(3,4-epoxycyclohexyl)ethyl]pentamethyl disiloxane, alicyclic epoxy compounds having the structure indicated by chemical formula (1), and the like.

A case in which the cationically polymerizable compound is composed of a polyfunctional cationically polymerizable compound and a monofunctional cationically polymerizable compound (hereinafter referred to as the polyfunctional-monofunctional combined cationically polymerizable composition) is preferred because the resulting composition for hologram recording can easily have high recording sensitivity. A polyfunctional-monofunctional combined cationically polymerizable composition in which the polyfunctional cationically polymerizable compound is a polyfunctional epoxy compound is more preferred, and a polyfunctional epoxy compound having a siloxane bond is even more preferred. The monofunctional cationically polymerizable compound is more preferably a monofunctional epoxy compound, and even more preferably a monofunctional epoxy compound having a siloxane bond. The reasons for these conditions are that a composition having good compatibility and uniformity can easily be obtained, and a composition for hologram recording having particularly high recording sensitivity can also easily be obtained. In the polyfunctional-monofunctional combined cationically polymerizable composition, the ratios of the polyfunctional cationically polymerizable compound and the monofunctional cationically polymerizable compound are preferably 50 to 90 mass% and 10 to 50 mass%, respectively, based on the total quantity of both compounds, and more preferably 50 to 80 mass% and 20 to 50 mass%, respectively. The degree to which the recording sensitivity is increased can be small if the ratio of the monofunctional cationically polymerizable compound is too low, and the composition can become clouded (have inadequate compatibility) if this ratio is too high.

The monofunctional epoxy compound is a compound having one oxirane ring per molecule, and includes known aromatic monofunctional epoxy compounds, alicyclic monofunctional epoxy compounds, aliphatic monofunctional epoxy compounds, and the like. An alicyclic monofunctional epoxy compound is particularly preferred as the monofunctional epoxy compound.

Preferred aromatic monofunctional epoxy compounds are glycidyl ethers manufactured by reacting a phenol compound having at least one aromatic nucleus or an alkylene oxide adduct thereof with epichlorohydrin, and examples include phenyl glycidyl ether, glycidyl 4-nonyl phenyl ether, and the like. The alkylene oxide in this case includes ethylene oxide, propylene oxide, or the like.

Preferred aliphatic monofunctional epoxy compounds are glycidyl ethers of an aliphatic alcohol or an alkylene oxide adduct thereof, and typical examples thereof include butyl glycidyl ether, glycidyl hexadecyl ether, and the like. The alkylene oxide in this case includes ethylene oxide, propylene oxide, or the like.

The alicyclic monofunctional epoxy compound is obtained by epoxidation of a compound having at least one cyclohexene or cyclopentene ring or other cycloalkane ring with hydrogen peroxide or another appropriate oxidizing agent. A compound containing a cyclohexene oxide or cyclopentene oxide is preferred, and specific examples thereof include 4-vinyl-1-cyclohexene-1,2-epoxide, methyl-3,4-epoxycyclohexane carboxylate, [2-(3,4-epoxycyclohexyl)ethyl] pentamethyl disiloxane, compounds having the structure indicated by chemical formula (2) below, and the like.

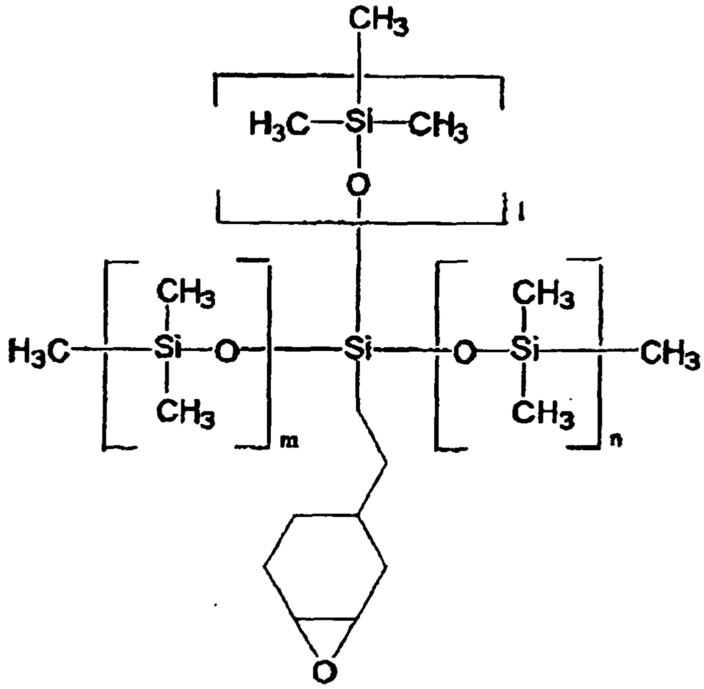

(2)

In formula (2), l, m, and n are all integers equal to 0 or above; at least one of l, m, and n is 1 or above; and l, m, and n are all integers equal to 10 or lower.

Any of the examples cited above can be used as the polyfunctional epoxy compound.

The admixed ratio of the cationically polymerizable compound is preferably 5 to 95 mass% based on 100 mass% of the composition for hologram recording, a ratio of 10 to 90 mass% is more preferred, and 20 to 85 mass % is ideal. Effects whereby holographic performance is enhanced are inadequate if the admixed ratio is too low or too large.

(Compound whose refractive index differs by 0.005 or more from that of a cured article of the cationically polymerizable compound)

The compound whose refractive index differs by 0.005 or more from that of a cured article of the cationically polymerizable compound is a necessary component for enabling hologram recording to be performed using the composition.

Compounds having a siloxane bond and a refractive index that differs by 0.005 or more from that of a cured article of the cationically polymerizable compound, as well as polysiloxanes, polyethers, polyacrylates, and polystyrenes are preferred as the compound whose refractive index differs by 0.005 or more from that of a cured article of the cationically polymerizable compound because they enable better hologram recording to be performed.

A compound whose refractive index differs by 0.01 or more from that of a cured article of the cationically polymerizable compound is preferred because it enables better hologram recording to be performed.

The admixed ratio of the compound whose refractive index differs by 0.005 or more from that of a cured article of the cationically polymerizable compound is preferably 5 to 95 mass% based on 100 mass% of the composition for hologram recording, more preferably 10 to 90 mass%, and ideally 10 to 70 mass%. Effects whereby holographic performance is enhanced are inadequate if the admixed ratio is too low or too large.

(Thermal cationic polymerization initiator)

The thermal cationic polymerization initiator is a necessary component for heating the composition for hologram recording in a liquid film state and causing heat curing of a portion of the cationically polymerizable compound prior to the step for performing irradiation with coherent light and inducing photocuring in order to form an interference pattern when a hologram is recorded using the composition for hologram recording. With this type of heat curing, the composition for hologram recording is capable of satisfactorily forming a thick holographic coating. Making the holographic coating thick increases the amount of information that can be recorded.

The thermal cationic polymerization initiator is a compound that generates an active species for causing cationic

polymerization of the cationically polymerizable compound by heating, and may be a single compound or a combination of a plurality of compounds. A known thermal cationic polymerization initiator may be used, but a combination of an aluminum compound and a compound having a silanol group is preferred as the thermal cationic polymerization initiator because of its excellent compatibility with the other components contained in the composition for hologram recording. The admixed ratio of the thermal cationic polymerization initiator is preferably 0.01 to 20 mass% based on 100 mass% of the composition for hologram recording, and more preferably 0.1 to 10 mass%. Heat-curability can become inadequate if the admixed ratio is too low, and the process is economically inefficient if this ratio is too high. The storage stability of the composition can also suffer, and the resulting composition can also have poor holographic performance.

A thermal cationic polymerization initiator composed of an aluminum compound and a compound having a silanol group, and heat curing of an epoxy compound using this initiator are publicly known (see JP-B-57-57487, JP-B-57-57488, JP-B-57-57489, JP-B-57-57490, JP-B-57-57491, JP-B-57-57492, JP-A-57-133122, JP-A-58-21418, JP-A-58-160342; *J. Polym. Sci, Polym Chem. Ed*. Vol. 19, pp. 2185-2194 (1981); *J. Polym. Sci., Polym. Chem. Ed*. Vol. 19, pp. 2977-2985 (1981); *J. Polym. Sci., Polym. Chem. Ed*. Vol. 20, pp. 3155-3165 (1982); *Polymers*, Vol. 35, February (1986); and other publications).

An aluminum compound or the like described in the above publications can be used as the aluminum compound. The aluminum compound that is preferred for use varies according to the type of the epoxy compound admixed into the composition and the like, but to cite examples thereof, aluminum *tris*(2,2,6,6-tetramethyl-3,5-heptanedionate), aluminum acetylacetonate, and aluminum *tris*-(ethylacetoacetate) among the aluminum compounds described in the aforementioned publications are preferred for their good compatibility or heat curing reaction characteristics with the epoxy compound, the ease with which good holograms can be recorded therewith, and their availability. These compounds are each indicated by the chemical formulae shown below.

Aluminum *tris*(2,2,6,6-tetramethyl-3,5-heptanedionate):

$$[(CH_3)_3CCOCH=C(O\text{-})C(CH_3)_3]_3Al$$

Aluminum acetylacetonate:

$$[CH_3COCH=C(O\text{-})CH_3]_3Al$$

Aluminum *tris*-(ethylacetoacetate):

$$[C_2H_5OCOCH=C(O\text{-})CH_3]_3Al$$

The admixed ratio thereof when an aluminum compound is used as the thermal cationic polymerization initiator is preferably 0.001 to 10 mass% based on 100 mass% of the composition for hologram recording, and more preferably 0.005 to 1 mass%.

The compounds having a silanol group described in the aforementioned publications are included as the compound having a silanol group that can be combined with the aluminum compounds for use as the thermal cationic polymerization initiator. The compound having a silanol group that is preferred for use varies according to the epoxy compound used and other factors, but to cite examples thereof, a dialkyl silicone having a silanol group, a diaryl silicone having a silanol group, an alkylaryl silicone having a silanol group, or another silicone compound having a silanol group is preferred for use.

The admixed ratio thereof when a compound having a silanol group is used as the thermal cationic polymerization initiator is preferably 0.01 to 20 mass% based on 100 mass% of the composition for hologram recording, and more preferably 0.1 to 5 mass%.

(Optical cationic polymerization initiator)

The optical cationic polymerization initiator is a necessary component for irradiating the cationically polymerizable compound with coherent light and photocuring the compound in order to form an interference pattern when a hologram is recorded using the composition for hologram recording.

The optical cationic polymerization initiator is a compound that generates an active species for causing cationic polymerization of the cationically polymerizable compound by irradiation with light. In the present invention, the term "light" includes visible light and ultraviolet rays. A publicly known optical cationic polymerization initiator can be used. Examples thereof include diazonium salts, triaryl sulfonium salts, phosphonium salts, diaryl iodonium salts, and ferrocenium salts. Diaryl iodonium salts can be cited as being preferred among these initiators. A typical diaryl iodonium salt is indicated by formula (3) below.

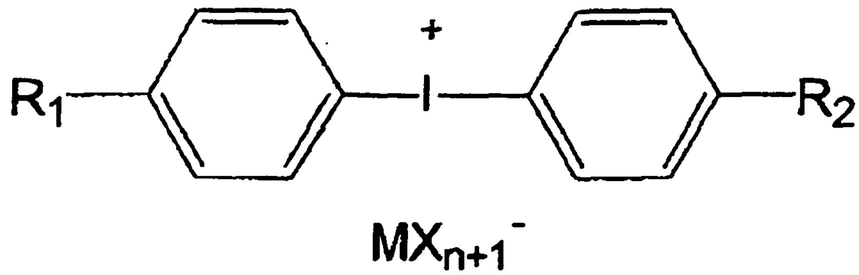

(3)

In formula (3), $R_1$ is a $C_1$-$C_8$ alkyl group, a $C_1$-$C_{18}$ alkoxy group, or the like; and $R_2$ is hydrogen, a $C_1$-$C_{18}$ alkyl group, a $C_1$-$C_{18}$ alkoxy group, or the like. M is a metal, boron, or phosphorus atom. X is a halogen atom or a halogen-containing group, and is preferably fluorine or a pentafluorophenyl group. The value n indicates the valence of M.

The admixed ratio of the optical cationic polymerization initiator is preferably 0.05 to 20 mass% based on 100 mass% of the composition for hologram recording, and is more preferably 0.5 to 10 mass%. Photocuring properties can become inadequate if the admixed ratio is too low, and not only is the process economically inefficient if this ratio is too high, but the resulting composition can also have poor holographic performance.

(Photosensitizing agent)

A photosensitizing agent may be added to the composition for hologram recording. The curability under optical irradiation can be improved by the addition of a photosensitizing agent according to the type of optical cationic polymerization initiator, the wavelength of the irradiating light, and the like. A publicly known compound can be used as the photosensitizing agent as long as it is susceptible to the light used during interference pattern formation. A dye is preferred for use.

For example, when a diaryl iodonium salt is used as the optical cationic polymerization initiator, and green laser light having a wavelength of 532 nm (secondary harmonic when a YAG laser with an oscillation wavelength of 1064 nm is used) is used as the irradiation light in order to form an interference pattern, 5,12-*bis*(phenylethynyl)naphthacene or rubrene is preferred for use.

The admixed ratio thereof when a photosensitizing agent is jointly used is preferably 0.001 to 10 mass% based on 100 mass% of the composition for hologram recording, and more preferably 0.01 to 1 mass%. Effects whereby photocuring properties are enhanced can become inadequate if the admixed ratio is too low, and not only is the process economically inefficient if this ratio is too high, but the resulting composition can also have poor holographic performance.

Besides the aforementioned components, it is also possible to admix viscosity adjustors, adhesion improvers, and the like into the composition for hologram recording.

(Curing method)

The composition for hologram recording can demonstrate excellent holographic performance by being treated according to the method described below. Specifically, this method is made up of a step for forming the composition for hologram recording into a liquid film; a step for heat curing the liquid film and forming a semi-cured film; and a step for irradiating the semi-cured film with coherent light and forming an interference pattern. The term "semi-cured film" used above connotes uniformly curing the cationically polymerizable compound in the area targeted for holographic recording on liquid films at a reaction rate greater than 0% but less than 100%, and does not connote curing the portion in the area targeted for hologram recording and not curing other portions. The degree of curing (ratio of reaction rate) of the semi-cured film is preferably 10 to 90%, and more preferably 20 to 80%.

The step for forming the composition for hologram recording into a liquid film includes forming the composition into a liquid film having the designed thickness. The thickness of the liquid film is preferably 0.005 to 7 mm, more preferably 0.01 to 5 mm, and ideally 0.02 to 3 mm. With the liquid film in the state of having been applied to a base material, in the state of having been filled into a vessel, or the like, the surface irradiated with light may be covered by a glass plate or other light-transmissive plate or film.

The step for heat curing the liquid film and forming a semi-cured film includes heating the liquid film to a temperature sufficient for the thermal cationic polymerization initiator admixed into the composition to be activated. This step is performed prior to the step for irradiating the semi-cured film with coherent light and forming an interference pattern. With this type of heat curing, the composition for hologram recording can be satisfactorily formed into a thick holographic coating. Making the holographic coating thick increases the amount of information that can be recorded.

The heating conditions vary according to the type or concentration of the cationically polymerizable compound or the thermal cationic polymerization initiator. Suitable heating conditions are such that the storage modulus of the resulting heat-cured article at 20˚C is $1\times10^4$ Pa or above, preferably $1\times10^5$ Pa or above. Suitable heating conditions are also such that the calorific value during photocuring for interference pattern formation after heat curing is 3% to 75%, preferably 10% to 50%, of the calorific value when the composition that has not been heat-cured is photocured. For example, the heating temperature is preferably 40 to 250˚C, and more preferably 50 to 200˚C; and the heating time is preferably 1 hour to 10 hours, and more preferably 2 hours to 5 hours.

If heat curing is inadequate, then fluctuation in the interference pattern can occur in the step for performing irradiation with coherent light and photocuring in order to form an interference pattern, and a good holographic recording is not obtained. If heat curing is excessive, it can be impossible to adequately form an interference pattern in the step for performing irradiation with coherent light and photocuring in order to form an interference pattern, and a good holographic recording is also not obtained.

A characteristic feature of the present invention is that heat curing is used to perform the partial curing (hereinafter referred to as pre-curing) of the composition for hologram recording performed prior to the step (hereinafter referred to as pattern formation curing) for performing irradiation with coherent light and photocuring in order to form an interference pattern. When pre-curing is performed by photocuring, a thick cured film is either difficult to obtain or holographic performance (diffractive efficiency, information capacity) is inadequate even when a cured film is obtained. It is believed that since the optical cationic polymerization initiator is consumed in pre-curing when photocuring is also employed in pre-curing, an adequate interference pattern is difficult to form in pattern formation curing.

The photocuring step for irradiating the semi-cured film, which has been partially cured by heat curing, with coherent light in order to form an interference pattern includes irradiating the semi-cured film with coherent light that is capable of causing an interference pattern to be formed in the partially heat-cured film, causing optical cationic polymerization of the unreacted cationically polymerizable compound, and recording a hologram. Laser light is commonly used as the coherent light. Another characteristic feature of the composition of the present invention is that since a cationically polymerizable compound is used as the optically polymerizable compound, and a radically polymerizable compound is not used (radical polymerization is not used in formation of the interference pattern), the curing shrinkage is minimal during pattern formation and curing, and a hologram that is faithful to the interference pattern can be recorded.

The cured article obtained such as described above may be subjected to further heat curing or photocuring as necessary.

Examples

The present invention will be more specifically described hereinafter using examples. In the following examples, "%" indicates mass%.

(Example 1)

A composition for hologram recording was prepared containing *bis*[2-(3,4-epoxycyclohexyl)ethyl]tetramethyl disiloxane as the cationically polymerizable compound, polymethylphenyl siloxane as the compound whose diffractive index differs from that of the cationically polymerizable compound (weight-average molecular weight: Mw = $1.85\times10^3$; diffractive index: $n_d^{20}$ = 1.537), aluminum *tris*(2,2,6,6-tetramethyl-3,5-heptanedionate) as the thermal cationic polymerization initiator, dimethyl silicone having silanol groups at both ends thereof (weight-average molecular weight: Mw = 2000), (tolylcumyl)iodonium *tetrakis*(pentafluorophenyl)borate as the optical cationic polymerization initiator, and the photosensitizing agent 5,12-*bis*(phenylethynyl)naphthacene in the ratios shown in Table 1.

The diffractive index of a cured article of bis[2-(3,4-epoxycyclohexyl)ethyl]tetramethyl disiloxane measured separately was $n_d^{20}$ = 1.501.

Table 1

| | Example 1 | Comparative Examples 1 and 2 |
|---|---|---|
| Aluminum tris(2,2,6,6-tetramethyl-3, 5-heptanedionate) | 0.048% | 0% |
| dimethyl silicone having silanol groups at both ends | 0.96% | 0% |
| bis [2-(3,4-epoxycyclohexyl) ethyl]tetramethyl disiloxane | 72.1% | 72.8% |
| polymethylphenyl siloxane | 24.0% | 24.3% |
| (tolycumyl)iodunium *tetrakis* (pentafluorophenyl) borate | 2.9% | 2.9% |

(continued)

| | Example 1 | Comparative Examples 1 and 2 |
|---|---|---|
| 5,12-bis(phenylethynyl) naphthacene | 0.029% | 0.029% |
| Total | 100% | 100% |

The composition was packed into a glass vessel and heated in an oven at 80˚C, and a heat-cured article having a thickness of approximately 500 μm was obtained. The results of the heat curing reaction are shown in Table 2.

Table 2

| Heating conditions | 80˚C×1h | 80˚C×1-25h | 80˚C×1.5h | 80˚C×2h |
|---|---|---|---|---|
| Example 1 | × | Δ | ○ | ○ |
| Comparative Example 1 | × | × | × | × |

The meanings of the symbols used for evaluation in Table 2 are shown below.
○: The composition for hologram recording in the glass vessel after heat treatment is in a gel state (a state of no fluidity)
Δ:The composition for hologram recording in the glass vessel after heat treatment is a mixture of gel and liquid states
X:The composition for hologram recording in the glass vessel after heat treatment is in a liquid state

Table 3 shows the storage modulus at 20˚C of the cured article cured at 80˚C for 1.5 hours, the calorific value when the cured article was irradiated with the light used during interference pattern formation, and the diffraction efficiency when the interference pattern was formed in the cured article. The calorific value when the composition that was not pre-cured was irradiated with light to form an interference pattern was 300 J/g.

Table 3

| | Storage modulus at 20˚C (Pa) | Calorific value (J/g) | Diffraction efficiency (%) |
|---|---|---|---|
| Example 1 | $7.5\times10^5$ | 79 | 45 |
| Comparative Example 2 | $3.3\times10^4$ | 46 | 30 |

(Comparative Example 1)

The composition shown in Table 1 was prepared without admixing the thermal cationic polymerization initiator to the composition of Example 1.

Since this composition did not have the cationic polymerization initiator admixed therein, the composition was not cured even when heated to 80˚C in the same manner as in Example 1, and remained in a liquid state (Table 2).

(Comparative Example 2)

The composition shown in Table 1 (the same composition as in Comparative Example 1) was prepared without admixing the thermal cationic polymerization initiator to the composition of Example 1.

The composition was packed into a glass vessel and pre-cured (subjected to non-holographic pre-imaging exposure) by irradiation with light at an intensity of 0.5 mW/cm$^2$ (500 nm), yielding a cured article having a thickness of approximately 500 μm. The cured article thus obtained had no tackiness on the irradiated surface, but had tackiness on the back surface thereof, and was unevenly cured.

Table 3 shows the storage modulus of the cured article at 20˚C, the calorific value when the cured article was irradiated with the light used during interference pattern formation, and the diffraction efficiency when the interference pattern was formed in the cured article.

(Measurement of storage modulus)

The storage modulus of the cured article at 20˚C for which pre-curing was performed by non-holographic pre-imaging exposure (Comparative Example 2) or heat treatment (Example 1) was measured by a VAR/DAR-type rheometer.

(Measurement of calorific value)

The calorific value of cured articles that had been pre-cured by non-holographic pre-imaging exposure with the light irradiation used during interference pattern formation (in the case of Comparative Example 2), or by heat treatment (in the case of Example 1), was measured using a differential scanning calorimeter (DSC220C) equipped with a UV lamp (UV-1), manufactured by Seiko Instruments Inc.

A filter was attached to the UV lamp so that the cured article was irradiated only with light having a wavelength of 480 nm to 550 nm. The intensity of the irradiating light was 0.16 $mW/cm^2$ (500 nm), air was circulated in the measured portion at a flow rate of 40 mL/min, and the ambient temperature was set to 20°C.

(Measurement of diffraction efficiency)

Laser light having a wavelength of 532 nm was used to form the interference pattern. Interference fringes were formed by dividing the laser light into two beams and causing the beams to intersect. The intensity of the irradiating light in each laser beam was 1.5 mW, and the beam spot diameter was 6 mm. The line perpendicular to the plane of the cured article was set as the 0-degree reference, and the cured article was irradiated with the aforementioned laser light for 60 seconds from angles ± 20.3 degrees in the same plane. At the same time, the interference portion was irradiated with laser light having a wavelength of 633 nm from +24.4 degrees or -24.4 degrees (the values calculated to be near the Bragg angle of the hologram), and the diffraction efficiency was measured.

The diffraction efficiency in the present specification was found from the following equation.

$$\text{Diffraction efficiency (\%)} = [(\text{Primary diffraction light intensity at a wavelength of 633 nm})/(\text{Incident light intensity at a wavelength of 633 nm})] \times 100$$

The value of the diffraction efficiency increased with increased time of irradiation (dose) with laser light at a wavelength of 532 nm, but was substantially saturated (the value no longer increased, and became substantially constant) after 60 seconds of irradiation with the laser light.

(Example 2)

Heat curing (pre-curing) was performed using the same composition as was used in Example 1, and it was possible to obtain a heat-cured article having a thickness of 2.4 mm. The storage modulus (20°C) of this heat-cured article is shown below together with the calorific value thereof when the heat-cured article was irradiated with the light used during interference pattern formation.

Storage modulus (20°C): $6.5 \times 10^5$ Pa/Calorific value: 82 J/g

(Examples 3 through 5)

The composition shown in Table 4 was prepared by the same operation as in Example 1 except that *bis*[2-(3,4-epoxycyclohexyl)ethyl]tetramethyl disiloxane (polyfunctional epoxy compound) and [2-(3,4-epoxycyclohexyl)ethyl]pentamethyl disiloxane (monofunctional epoxy compound) were jointly used as the cationically polymerizable compound, and the product was evaluated as described hereinafter. The diffractive index of cured [2-(3,4-epoxycyclohexyl)ethyl] pentamethyl disiloxane measured separately was $n_d^{20}$ = 1.468.

Table 1

| | Example 3 | Example 4 | Example 5 |
|---|---|---|---|
| Aluminum *tri*s (2,2,6,6-tetramethyl-3,5-heptanedionate) | 0.048% | 0.048% | 0.048% |
| dimethyl silicone having silanol groups at both ends | 0.99% | 0.99% | 0.99% |
| bis [2-(3,4-epoxycyclohexyl) ethyl] tetramethyl disiloxane | 44.6% | 54.1% | 61.2% |

(continued)

| | Example 3 | Example 4 | Example 5 |
|---|---|---|---|
| [2-(3,4-opoxycyclohexyl) ethyl]pentamethyl disiloxane | 27.4% | 18.0% | 10.9% |
| polymethylphenyl siloxane | 24.0% | 24.0% | 24.0% |
| (tolylcumyl) iodonium *tetrakis* (pentafluorophenyl) borate | 2.9% | 2.9% | 2.9% |
| 5,12-bis (phenylethynyl) naphthacene | 0-029% | 0.029% | 0.029% |
| Total | 100% | 100% | 100% |

The composition was packed into a glass vessel and heated in an oven at 80˚C, yielding a heat-cured article having a thickness of approximately 500 μm. The results of the heat curing reaction are shown in Table 5. The meanings of the symbols used for evaluation in Table 5 are the same as those in Table 2.

Table 5

| Heating conditions | 80˚C×1h | 80˚C×1.5h | 80˚C×2h | 80˚C×2.5h | 80˚C×3h |
|---|---|---|---|---|---|
| Example 3 | × | × | Δ | Δ | ○ |
| Example 4 | Δ | Δ | Δ | ○ | - |
| Example 5 | Δ | Δ | ○ | - | - |

Table 6 shows the time elapsed until a gel state was reached at 80˚C (3 hours, 2.5 hours, and 2 hours for Examples 3, 4, and 5, respectively), the storage modulus of the cured article at 20˚C, the calorific value when the cured article was irradiated with the light used during interference pattern formation, the diffraction efficiency when the interference pattern was formed in the cured article, and the recording sensitivity. The calorific value was 300 J/g when the composition that was not pre-cured was irradiated with light used to form the interference pattern.

Table 6

| | Storage modulus at 20˚C (Pa) | Calorific Value (J/g) | Diffraction efficiency (%) | Recording sensitivity (cm/mJ) |
|---|---|---|---|---|
| Example 3 | $5.6\times10^{4}$ | 116 | 37 | $1.6\times10^{-1}$ |
| Example 4 | $7.4\times10^{5}$ | 37 | 38 | $1.2\times10^{-1}$ |
| Example 5 | $2.6\times10^{5}$ | 62 | 38 | $7.9\times10^{-2}$ |

The storage modulus and calorific value were measured by the same operation as in Example 1. The diffraction efficiency was measured by the same operation as in Example 1, but the intensity of the laser light at a wavelength of 532 nm had changed to 1.3 mW, and the beam spot diameter to 5 mm.

(Computation of recording sensitivity)

The recording sensitivity S (cm/mJ) was computed from the equation below.

$$S = \delta / L$$

In the equation, δ is a datum in the measurement operation of the diffraction efficiency, and is a value found from the slope of a straight line connecting two points (the points at which $\eta^{1/2}$ = 0.1 and 0.4) on the graph when the cumulative amount E (mJ/cm$^2$) of laser light irradiation at a wavelength of 532 nm and $\eta^{1/2}$ (the square root of the diffraction efficiency η) are plotted on the horizontal and vertical axes, respectively.
L: Thickness (cm) of the sample (composition for hologram recording)

INDUSTRIAL APPLICABILITY

With the composition for hologram recording of the present invention, there is minimal curing shrinkage during interference pattern formation, virtually all of the polymerization initiator or photosensitizing agent admixed therein can be utilized during interference pattern formation, and a thick, satisfactory holographic coating that has high recording sensitivity can be obtained. Specifically, the composition for hologram recording of the present invention can be suitably used for volume hologram recording.

## Claims

**1.** A composition for hologram recording comprising a cationically polymerizable compound, a compound whose refractive index differs by 0.005 or more from that of a cured article of the cationically polymerizable compound, a thermal cationic polymerization initiator, and an optical cationic polymerization initiator.

**2.** A composition for hologram recording containing 5 to 95 mass% of a cationically polymerizable compound; 5 to 95 mass% of a compound whose refractive index differs by 0.005 or more from that of a cured article of the cationically polymerizable compound; 0.01 to 20 mass% of a thermal cationic polymerization initiator; and 0.05 to 20 mass% of an optical cationic polymerization initiator based on 100 mass% of the composition for hologram recording.

**3.** The composition for hologram recording according to claim 1 or claim 2, wherein the cationically polymerizable compound is an epoxy compound.

**4.** The composition for hologram recording according to claim 1 or claim 2, wherein the cationically polymerizable compound comprises a polyfunctional cationically polymerizable compound and a monofunctional cationically polymerizable compound.

**5.** The composition for hologram recording according to claim 4, wherein the polyfunctional cationically polymerizable compound is a polyfunctional epoxy compound having a siloxane bond.

**6.** The composition for hologram recording according to claim 4, wherein the monofunctional cationically polymerizable compound is a monofunctional epoxy compound having a siloxane bond.

**7.** The composition for hologram recording according to any of claims 1 through 6, wherein the thermal cationic polymerization initiator is composed of an aluminum compound and a compound having a silanol group.

**8.** The composition for hologram recording according to claim 7, wherein the admixed ratio of the aluminum compound is 0.001 to 10 mass%, and the admixed ratio of the compound having a silanol group is 0.01 to 20 mass% based on 100 mass% of the composition for hologram recording.

**9.** A curing method for a composition for hologram recording, comprising the steps of:

forming the composition for hologram recording according to any of claims 1 through 8 into a liquid film;
heat curing the liquid film and forming a semi-cured film; and
irradiating the semi-cured film with coherent light and forming an interference pattern.

**10.** A cured article obtained by the method according to claim 9.

## Patentansprüche

**1.** Zusammensetzung zur Hologrammaufzeichnung, welche eine kationisch polymerisierbare Verbindung, eine Verbindung, deren Brechungsindex sich um 0,005 oder mehr von dem eines ausgehärteten Gegenstands der kationisch polymerisierbaren Verbindung unterscheidet, einen kationischen Wärmepolymerisationsstarter und einen kationischen Lichtpolymerisationsstarter umfasst.

**2.** Eine Zusammensetzung zur Hologrammaufzeichnung, die basierend auf 100 Masse-% der Zusammensetzung zur Hologrammaufzeichnung das Folgende beinhaltet: 5 bis 95 Masse-% einer kationisch polymerisierbaren Verbindung; 5 bis 95 Masse-% einer Verbindung, deren Brechungsindex sich um 0,005 oder mehr von dem eines gehärteten Gegenstands der kationisch polymerisierbaren Verbindung unterscheidet; 0,01 bis 20 Masse-% eines kationischen Wärmepolymerisationsstarters; und 0,05 bis 20 Masse-% eines kationischen Lichtpolymerisationsstarters, und zwar.

**3.** Die Zusammensetzung zur Hologrammaufzeichnung gemäß Anspruch 1 oder Anspruch 2, wobei die kationisch polymerisierbare Verbindung eine Epoxidverbindung ist.

**4.** Die Zusammensetzung zur Hologrammaufzeichnung gemäß Anspruch 1 oder Anspruch 2, wobei die kationisch polymerisierbare Verbindung eine polyfunktionelle, kationisch polymerisierbare Verbindung und eine monofunktionelle, kationisch polymerisierbare Verbindung umfasst.

**5.** Die Zusammensetzung zur Hologrammaufzeichnung gemäß Anspruch 4, wobei die polyfunktionelle, kationisch polymerisierbare Verbindung eine polyfunktionelle Epoxidverbindung mit einer Siloxanbindung ist.

**6.** Die Zusammensetzung zur Hologrammaufzeichnung gemäß Anspruch 4, wobei die monofunktionelle, kationisch polymerisierbare Verbindung eine monofunktionelle Epoxidverbindung mit einer Siloxanbindung ist.

**7.** Die Zusammensetzung zur Hologrammaufzeichnung gemäß irgendeinem der Ansprüche 1 bis 6, wobei der kationische Wärmepolymerisationsstarter sich aus einer Aluminiumverbindung und einer Verbindung mit einer Silanolgruppe zusammensetzt.

**8.** Die Zusammensetzung zur Hologrammaufzeichnung gemäß Anspruch 7, wobei das Beimischungsverhältnis der Aluminiumverbindung bei 0,001 bis 10 Masse-% liegt und das Beimischungsverhältnis der Verbindung mit einer Silanolgruppe bei 0,01 bis 20 Masse-% liegt, basierend auf 100 Masse-% der Zusammensetzung zur Hologrammaufzeichnung.

**9.** Ein Aushärtungsverfahren für eine Zusammensetzung zur Hologrammaufzeichnung, welches die folgenden Schritte umfasst:

Ausbilden der Zusammensetzung zur Hologrammaufzeichnungen gemäß irgendeinem der Ansprüche 1 bis 8 in Form eines flüssigen Films;
Wärmeaushärten des flüssigen Films und Erzeugen eines semiausgehärteten Films; und
Bestrahlen des semiausgehärteten Films mit kohärentem Licht und Erzeugen eines Interferenzmusters.

**10.** Ein ausgehärteter Gegenstand, der durch das Verfahren gemäß Anspruch 9 erhalten wird.

## Revendications

**1.** Composition d'enregistrement d'hologramme comprenant un composé cationiquement polymérisable, un composé dont l'indice de réfraction diffère de 0,005 ou plus de celui d'un article durci du composé cationiquement polymérisable, un initiateur de polymérisation cationique thermique, et un initiateur de polymérisation cationique optique.

**2.** Composition d'enregistrement d'hologramme contenant 5 à 95 % en masse d'un composé cationiquement polymérisable ; 5 à 95 % en masse d'un composé dont l'indice de réfraction diffère de 0,005 ou plus de celui d'un article durci du composé cationiquement polymérisable ; 0,01 à 20 % en masse d'un initiateur de polymérisation cationique thermique ; et 0,05 à 20 % en masse d'un initiateur de polymérisation cationique optique basé sur 100 % en masse de la composition pour l'enregistrement d'hologramme.

**3.** Composition d'enregistrement d'hologramme selon la revendication 1 ou la revendication 2, dans laquelle le composé cationiquement polymérisable est un composé époxy.

**4.** Composition d'enregistrement d'hologramme selon la revendication 1 ou la revendication 2, dans laquelle le composé cationiquement polymérisable comprend un composé polyfonctionnel cationiquement polymérisable et un composé monofonctionnel cationiquement polymérisable.

**5.** Composition d'enregistrement d'hologramme selon la revendication 4, dans laquelle le composé polyfonctionnel cationiquement polymérisable est un composé époxy polyfonctionnel ayant une liaison siloxane.

**6.** Composition d'enregistrement d'hologramme selon la revendication 4, dans laquelle le composé monofonctionnel cationiquement polymérisable est un composé époxy monofonctionnel ayant une liaison siloxane.

**7.** Composition d'enregistrement d'hologramme selon l'une quelconque des revendications 1 à 6, dans laquelle l'initiateur de polymérisation cationique thermique est composé d'un composé aluminium et d'un composé ayant un groupe silanol.

**8.** Composition d'enregistrement d'hologramme selon la revendication 7, dans laquelle le rapport d'admixtion du composé aluminium est de 0,001 à 10 % en masse, et le rapport d'admixtion du composé ayant un groupe silanol est de 0,01 à 20 % en masse basé sur 100 % en masse de la composition d'enregistrement d'hologramme.

**9.** Procédé de durcissement d'une composition d'enregistrement d'hologramme, comprenant les étapes de :

formation de la composition d'enregistrement d'hologramme selon l'une quelconque des revendications 1 à 8 en un film liquide ;
durcissement thermique du film liquide et formation d'un film semi-durci ; et
irradiation du film semi-durci avec de la lumière cohérente et formation d'un profil d'interférences.

**10.** Article durci obtenu par le procédé selon la revendication 9.